# EUROPÄISCHE PATENTSCHRIFT

(11) **EP 2 649 869 B1**
(45) Veröffentlichungstag und Bekanntmachung des Hinweises auf die Patenterteilung: **25.05.2016**
(21) Anmeldenummer: 11770802.4
(22) Anmeldetag: 20.10.2011
(51) Int. Cl.: H05K 5/06, H05K 5/00, H05K 3/28

(54) **STEUERMODUL UND VERFAHREN ZU SEINER HERSTELLUNG**
CONTROL MODULE AND PROCESS OF FABRICATION
MODULE DE CONTRÔLE ET MÉTHODE POUR SA PRÉPARATION

(30) Priorität: 08.12.2010 DE 102010062653
(43) Veröffentlichungstag der Anmeldung: 16.10.2013
(73) Patentinhaber: Robert Bosch GmbH, 70442 Stuttgart (DE)
(72) Erfinder: OTT, Harald, 71691 Freiberg Am Neckar (DE)
(86) Internationale Anmeldenummer: PCT/EP2011/068311
(87) Internationale Veröffentlichungsnummer: WO 2012/076232

(56) Entgegenhaltungen:
- EP-A2- 0 309 920
- WO-A1-2006/066983
- WO-A1-2006/077208
- DE-A1-102007 019 096
- DE-A1-102007 029 913
- DE-A1-102007 032 594
- US-B1- 6 195 267

## Beschreibung

### Stand der Technik

Die Erfindung betrifft ein Steuermodul mit den Merkmalen des Oberbegriffs des unabhängigen Anspruchs 1 und ein Verfahren zu seiner Herstellung.

In der Getriebesteuerung sind Steuermodule bekannt, die ein elektronisches Steuergerät mit einem für die elektrische Kontaktierung des Steuergeräts mit Aktuatoren, Sensoren, Steckerteilen oder Stellmotoren vorgesehenen Grundträger zu einer Modulbaueinheit vereinen. Bekannte Getriebesteuermodule weisen häufig als Grundträger einen Kunststoffträger mit daran festgelegten metallischen Stanzgitterteilen zur Darstellung der elektrischen Verbindungen auf. Ein solches Getriebesteuermodul ist beispielsweise aus der DE 101 61 230 A1 bekannt. An dem Getriebesteuermodul kann ein Steuergerät angeordnet sein, wie es beispielsweise aus der DE 196 40 466 B4 bekannt ist. Die Steuerschaltung ist dabei auf einem Trägersubstrat in einem geschlossenen metallischen Gehäuse angeordnet und wird über Kontaktstifte in Glasdurchführungen mit den Stanzgitterteilen des Grundträgers kontaktiert. Neben solchen Steuermodulen, die einen Grundträger auf der Basis von Stanzgitterteilen verwenden, sind auch Getriebesteuermodule bekannt, die eine an einem Grundträger festgelegte Verkabelung zur Kontaktierung von Aktuatoren, Sensoren und Steckerteilen verwenden. Ein solches Getriebesteuermodul zeigt beispielsweise die WO 2005/044632 A1.

Außer den oben dargestellten bekannten Steuermodulen sind in den letzten Jahren weitere Typen entwickelt worden, die eine flexible Leiterfolie zur Kontaktierung zwischen dem elektronischen Schaltungsteil des Steuergerätes und den verschiedenen elektrischen Komponenten des Moduls verwenden. Derartige Getriebesteuermodule sind beispielsweise in der EP 1 831 055 B1 und in der DE 10 2005 002 813 B4 beschrieben worden. Die flexiblen Leiterfolien sind jedoch relativ teuer. Zudem ist ein nicht unerheblicher Aufwand zur Stützung und zum Schutz der Leiterfolie und zur Abdichtung zwischen dem Steuergerät und der Leiterfolie erforderlich.

In letzter Zeit sind Getriebesteuermodule entwickelt worden, die als Grundträger eine konventionelle starre oder auch starr-flexible Leiterplatte auf FR4 Basis oder höherwertig als Grundträger der elektrischen Verbindungstechnik einsetzen. Dabei werden die elektrischen Verbindungen vorzugsweise über Leiterbahnen in mehreren Ebenen der Leiterplatte geführt, was gegenüber den flexiblen Leiterfolien mit nur einer Verdrahtungsebene einen großen Vorteil aufweist. Im Unterschied zu den klassischen Steuergeräten, welche beispielsweise aus der EP 1 116 422 B1 bekannt sind, und welche eine Mehrlagenleiterplatten mit einer darauf angeordneten elektronischen Steuerschaltung in einem geschlossenen Metallgehäuse anordnen, benutzen die neueren Getriebesteuermodule eine konventionelle Leiterplatte als Grundträger des Moduls auch außerhalb des durch metallische oder Kunststoffgehäuseteile geschützten Bereichs. Derartige Module sind aufgrund der Verwendung der preiswerten und gut beherrschten Leiterplattentechnik besonders kostengünstig herstellbar. Ein solches Getriebesteuermodul ist beispielsweise aus der gattungsbildenden DE 10 2007 029 913 A1 bekannt. Da Getriebesteuermodule im Getriebe verbaut werden und dort dem Getriebefluid ausgesetzt sind, werden somit auch Teile der den Grundträger darstellenden Leiterplatte dem aggressiven Getriebefluid ausgesetzt. Die Verwendung von konventionellen Leiterplatten als Träger der elektrischen Verbindungstechnik im Getriebefluid erfordert neue Aufbau- und Verbindungskonzepte.

### Offenbarung der Erfindung

### Vorteile der Erfindung

Das erfindungsgemäße Steuermodul geht aus von dem aus der DE 10 2007 029 913 A1 bekannt gewordenen Typ von Getriebesteuermodulen, welche als Grundträger eine Leiterplatte mit auf wenigstens einer Ebene der Leiterplatte angeordnete Leiterbahnen verwenden. Vorzugsweise kommen Mehrlagenleiterplatten zum Einsatz. Die Leiterplatte kann entweder komplett starr sein oder neben starren, nicht flexiblen Leiterbahnabschnitten auch flexible Bereiche aufweisen. Mit den Leiterbahnen der Leiterplatte ist eine diskrete elektrische Bauelemente aufweisende, elektronische Steuerschaltung kontaktiert. Zum Schutz der Steuerschaltung ist ein wannenförmiges Deckelteil vorgesehen, das über der elektronischen Steuerschaltung angeordnet ist und mit einem parallel zu einer ersten Seite der Leiterplatte ausgerichteten, flanschartigen Kragen mit einem ebenen Auflagebereich auf der ersten Seite der Leiterplatte dichtend aufliegt. Die elektronischen Steuerschaltung ist im Gehäuseinnenraum zwischen Deckelteil und Leiterplatte geschützt angeordnet. Außerhalb des von dem Deckelteil abgedeckten Gehäuseinnenraums weist die Leiterplatte Kontakte zur Kontaktierung von elektrischen Komponenten des Steuermoduls, beispielsweise Steckern, Sensoren und Aktuatoren auf.

Vorteilhaft ist wenigstens ein Teil der elektronischen Steuerschaltung, insbesondere aber auch die gesamte elektronische Steuerschaltung, auf ein Trägersubstrat aufgebracht, das unabhängig von der Leiterplatte hergestellt und geprüft werden kann. Beispielsweise kann es sich um ein keramisches Trägersubstrat, ein LTCC-Substrat (Low temperature cofired ceramic) oder eine Mikroleiterplatte handeln, wobei die elektrische Kontaktierung der zur Steuerschaltung gehörenden elektrischen Bauelemente durch Leiterbahnen und Kontakte des Trägersubstrats gebildet werden. Die Kontaktierung kann dabei in einem geometrisch engeren Raster und kleineren, Abmessungen als auf der Leiterplatte des Moduls vorgenommen werden. Dabei ist es insbesondere auch möglich, ein Mehrlagensubstrat, beispielsweise ein keramisches Multilayersubstrat zu verwenden, bei dem die Kontaktierung über mehrere Lagen des Trägersubstrats geführt sind. Die auf dem handlichen Trägersubstrat erzeugte elektronische Schaltung kann somit unabhängig von der relativ großen Leiterplatte des Moduls gefertigt und geprüft werden. Das Trägersubstrat mit der darauf aufgebrachten Schaltung kann in einfacher Weise mit den Leiterbahnen der Leiterplatte kontaktiert werden. Hierfür kommen beispielsweise Bonddrähte in Frage, welche Kontaktstellen auf dem Trägersubstrat mit Leiterbahnen oder Kontaktflächen auf einer ersten Seite der Leiterplatte kontaktieren. Das Trägersubstrat kann aber auch mittels Lötkontakten auf der Unterseite direkt auf die Leiterbahnen oder Kontaktflächen der Leiterplatte aufgelötet werden. Das Trägersubstrat mit der Schaltung ist somit in einem Gehäuseinnenraum zwischen dem wannenförmigen Deckelteil und der Leiterplatte geschützt angeordnet.

Um das Eindringen von Getriebefluid in den Gehäuseinnenraum und eine Beschädigung der elektrischen Bauelemente möglichst zuverlässig zu verhindern, wird der Gehäuseinnenraum über den elektrischen Bauelementen und dem Trägersubstrat mit einem fließfähigen Material gefüllt. Durch die Kontaktierung des Trägersubstrats mit der Leiterplatte im dichten Gehäuseinnenraum und die Herausführung der elektrischen Verbindung durch die Leiterbahnen der Leiterplatte ist ein guter Schutz gegen Späne und Getriebefluid, beispielsweise aggressive Öle gewährleistet.

Vorteilhafte Ausbildungen und Weiterentwicklungen der Erfindung werden durch die in den abhängigen Ansprüchen angegebenen Maßnahmen ermöglicht.

So ist es besonders vorteilhaft, wenn das fließfähige Material den nicht durch das Trägersubstrat und die elektrischen Bauelemente belegten Teil des Gehäuseinnenraumes weitgehend ausfüllt und vorzugsweise vollkommen ausfüllt. In diesem Fall kann nicht nur das Getriebefluid nicht in den Gehäuseinnenraum eindringen, sondern es wird über das fließfähige Material auch ein Wärmeleitkontakt zwischen den auf dem Trägersubstrat angeordneten Bauelementen und dem Deckelteil hergestellt.

Das fließfähige Material kann vorteilhaft nach der Herstellung des Getriebesteuermoduls und nach Prüfung der Schaltungsfunktionen durch wenigstens eine in dem Deckelteil oder in der Leiterplatte vorgesehene Öffnung eingefüllt werden. Natürlich sind auch mehrere Öffnungen möglich. Die Öffnung kann anschließen mit einem Verschlusselement verschlossen werden. Bei dem fließfähigen Material kann es sich auch um ein beim Einfüllen zunächst flüssiges und danach aushärtendes Material handeln. Es kann sich insbesondere auch um eine wärmeleitendes Material handeln. Vorzugsweise wird eine wärmeleitende Flüssigkeit oder ein wärmeleitendes Gel verwandt. Die Öffnung hat auch den Vorteil, dass bei der Herstellung der Verbindung zwischen dem Deckelteil und der Leiterplatte bei Zufuhr von Wärme ein Luftaustausch zwischen dem Gehäuseinnenraum und der Atmosphäre stattfinden kann und ein Abplatzen des Deckelteils vermieden wird.

Zur Verbesserung der Wärmeableitung kann ein Kühlkörper über dem Deckelteil angeordnet werden, der mittel- oder unmittelbar mit dem Deckelteil in Wärmeleitkontakt steht. Dieser Kühlkörper kann auch Teil eines Grundkörpers des Steuermoduls sein.

Die verschließbare Öffnung kann besonders einfach in dem Deckelteil vorgesehen werden und mit einem eingepressten, insbesondere kugelförmigen Einpressteil als Verschlusselement verschlossen werden. Dies ist besonders vorteilhaft in Kombination mit einem metallischen Deckelteil. Das Deckelteil kann aber auch als Kunststoffteil ausgebildet sein.

In einem Ausführungsbeispiel ist vorgesehen, dass die verschließbare Öffnung in Form einer mit einer zentrischen Durchgangsausnehmung versehenen Durchkontaktierung in der Leiterplatte vorgesehen ist. Diese Durchkontaktierung kann vorteilhaft direkt bei der Fertigung der Leiterplatte eingeplant werden, was keinen zusätzlichen Aufwand erfordert. Das Verschlusselement kann nach der Befüllung mit wärmeleitenden Material in einfacher Weise in Form von Lot in die zentrische Durchgangsausnehmung eingebracht werden.

In einem vorteilhaften Ausführungsbeispiel wird eine metallische Grundplatte auf die von dem Deckelteil abgewandte zweite Seite der Leiterplatte aufgebracht. Das Trägersubstrat kann dann zur Verbesserung der Wärmeableitung innerhalb einer in der Leiterplatte vorgesehenen Ausnehmung auf die metallische Grundplatte aufgebracht werden. Die Wärme von den elektrischen Bauelementen auf dem Trägersubstrat erzeugte Wärme wird dann zusätzlich über das Trägersubstrat an die metallische Grundplatte abgegeben.

Weiterhin vorteilhaft ist ein Verfahren zur Herstellung eines Steuermoduls mit den folgenden Schritten:
- Bereitstellen eines mit einer elektronischen Steuerschaltung versehenen Trägersubstrats,
- Aufbringung des Trägersubstrats auf eine Leiterplatte oder Aufbringung des Trägersubstrats innerhalb einer Ausnehmung einer Leiterplatte auf eine mit der Leiterplatte verbundene metallische Grundplatte,
- Herstellung einer elektrischen Verbindung zwischen der elektronischen Steuerschaltung auf dem Trägersubstrat und den Leiterbahnen oder Kontaktflächen der Leiterplatte,
- Aufsetzen eines wannenförmigen Deckelteils über der elektronischen Steuerschaltung, so dass das wannenförmige Deckelteil mit einem ebenen Auflagebereich unter Herstellung einer umlaufend dichten Verbindung auf einer ersten Seite der Leiterplatte aufliegt,
- Einfüllung eines wärmeleitenden Materials durch eine Öffnung in dem Deckelteil oder der Leiterplatte in den zwischen dem Deckelteil und der Leiterplatte gebildeten Gehäuseinnenraum und
- Verschließen der Öffnung mit einem Verschlusselement.

Das Verfahren ist besonders kostengünstig und einfach durchzuführen, da die auf dem Trägersubstrat befindliche elektronische Schaltung vorab geprüft werden kann und die Anordnung des Trägersubstrats und des Deckelteils auf der Leiterplatte zusammen mit dem anschließenden Befüllungsvorgang des Gehäuseinnenraums relativ einfach automatisiert durchführbar sind.

Vorteilhaft kann noch vor dem Prozessschritt des Einfüllens des wärmeleitenden Materials über die wenigstens eine Öffnung im Deckelteil oder der Leiterplatte zunächst eine Dichtheitsprüfung des Gehäuseinnenraums durch eine Überdruck- oder Unterdruckbeaufschlagung erfolgen.

### Kurze Beschreibung der Zeichnungen

Ausführungsbeispiele der Erfindung sind in den Zeichnungen dargestellt und werden in der nachfolgenden Beschreibung näher erläutert. Es zeigen
- Figur 1: der prinzipielle Aufbau eines Ausführungsbeispiels des Getriebesteuermoduls mit einer flexibel-starren Leiterplatte,
- Figur 2: einen Teilquerschnitt durch ein erstes Ausführungsbeispiel eines erfindungsgemäßen Steuermoduls,
- Figur 3: einen Teilquerschnitt durch ein zweites Ausführungsbeispiel eines erfindungsgemäßen Steuermoduls,
- Figur 4: einen Teilquerschnitt durch ein drittes Ausführungsbeispiel eines erfindungsgemäßen Steuermoduls,
- Figur 5: einen Teilquerschnitt durch ein viertes Ausführungsbeispiel eines erfindungsgemäßen Steuermoduls,
- Figur 6: einen Teilquerschnitt durch ein fünftes Ausführungsbeispiel eines erfindungsgemäßen Steuermoduls,
- Figur 7: eine vergrößerte Detailansicht einer mit Lot verschlossenen Durchkontaktierung in einer Leiterplatte bei den Ausführungsbeispielen der Figuren 4 bis 6.

### Ausführungsformen der Erfindung

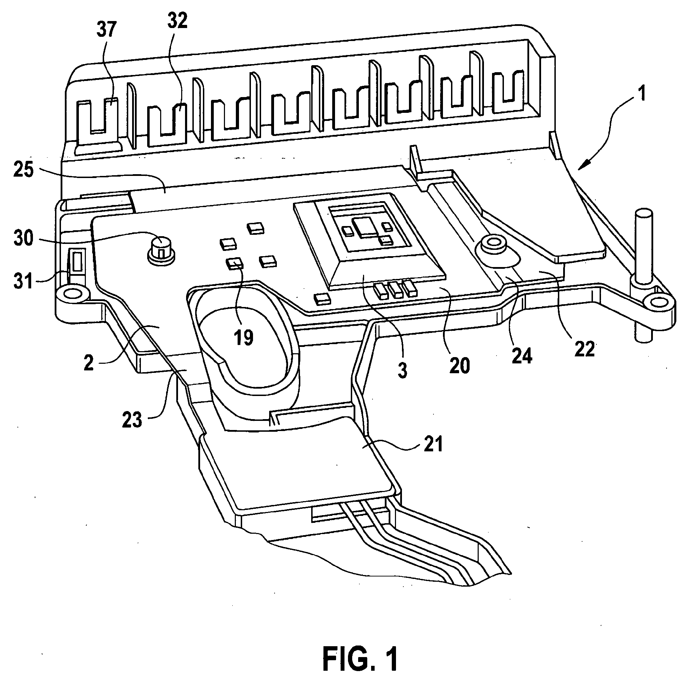

Figur 1 zeigt schematisch ein Steuermodul, welches vorzugsweise im Automatikgetriebe eines Kraftfahrzeuges verbaut werden kann. Obwohl hier am Beispiel eines Getriebesteuermoduls erläutert, kann das Steuermodul auch zur Ansteuerung anderer Aggregate verwandt werden, wobei das Steuermodul selbstverständlich an die jeweils erforderlichen Rahmenbedingungen, wie Anzahl und Art der anzusteuernden Aktuatoren, Sensoren und Steckanschlüsse anzupassen ist. Das hier dargestellte Getriebesteuermodul 1 weist beispielsweise ein komplexes Kunststoffteil als Grundkörper 1 auf, wobei Kontaktelemente 32 in Form von metallischen Messerkontakten zur Kontaktierung von Aktuatoren, beispielsweise elektrohydraulischen Drucksteuerventilen, direkt in den Grundkörper 1 eingebracht sein können. An dem Grundkörper 1 ist eine Leiterplatte 2 angeordnet, welche den Grundträger der elektrischen Verbindungstechnik darstellt. Die Leiterplatte 2 dient dazu die verschiedenen elektrischen Komponenten des Moduls, wie Aktuatoren, Sensoren und Stecker mit einem zentralen Steuergerät elektrisch zu verbinden. Bei der Leiterplatte 2 handelt es sich beispielsweise um eine konventionelle Leiterplatte aus glasfaserverstärktem Epoxidharz oder einem ähnlichen Material. In Frage kommen insbesondere FR4-Substrate oder höherwertige Leiterplattensubstrate. Der Grundkörper 1 kann entfallen, wenn die Leiterplatte dessen mechanische Befestigungsfunktion übernimmt und alle Komponenten des Steuermoduls direkt an der Leiterplatte befestigt sind.

In dem Ausführungsbeispiel der Figur 1 weist die Leiterplatte 2 wenigstens einen starren, nicht flexiblen Abschnitt für die Anordnung einer Steuerschaltung auf. Unter einer starren Leiterplatte wird im Kontext der Anmeldung eine Leiterplatte verstanden, welche in etwa die Elastizität einer herkömmlichen Leiterplatte auf FR4-Basis aufweist. Flexible Leiterfolien, auch Flexfolien genannt, fallen nicht darunter. Im Unterschied zu den starren Leiterplatten sind flexible Leiterfolien voll elastisch und weisen in jedem Teilbereich eine hohe Flexibilität und Biegsamkeit auf. Unter dem Begriff Leiterplatte soll aber auch eine sogenannte flexibel-starre Leiterplatte subsumiert werden, welche sowohl starre Abschnitte als auch flexible beziehungsweise elastisch verformbare Abschnitte aufweist. Derartige flexibel-starre Leiterplatten sind im Handel bekannt und beispielsweise beschrieben worden im "Handbuch der Leiterplattentechnik, Band 2 Neue Verfahren, neue Technologien, Eugen G. Leuze Verlag 1991 Saulgau Württemberg, Seite 99ff."

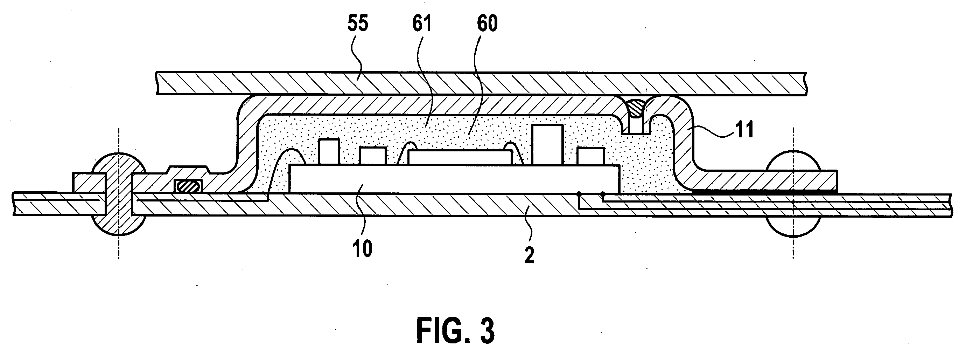

In Figur 1 ist weiterhin erkennbar, dass die Leiterplatte 2 einen zentralen starren Abschnitt 20 aufweist, der über flexible Bereiche 23, 24, 25 der Leiterplatte 2 mit weiteren starren Leiterplattenäbschnitten 21 und 22 verbunden ist. Ein zusätzlicher starrer Abschnitt 37 der Leiterplatte 2 kann beispielsweise zur Kontaktierung eines Aktuators in den Grundkörper 1 aufgenommen sein. Die Leiterplatte 2 ist in dem zentralen starren Abschnitt 20 mit einem Steuergerät 3 versehen, wie im Folgenden anhand der Figuren 3 bis 7 noch erläutert wird. Figur 1 zeigt, dass außerhalb des mit dem Steuergerät 3 versehenen Teils der Leiterplatte elektrische Komponenten auf die Leiterplatte bestückt sind. Dabei handelt es sich beispielsweise um Sensoren 30, einzelne elektrische Bauelemente 19 oder interne Steckanschlüsse 31. Aber auch die metallischen Kontaktelemente 32 der Aktuatoren sind mit einem in Figur 1 nicht erkennbaren starren Abschnitt der Leiterplatte 2 verbunden, der über einen weiteren flexiblen Abschnitt 25 an den zentralen Abschnitt 20 angeschlossen ist.

Die Leiterplatte 2 weist Leiterbahnen auf, die in wenigstens einer Ebene der Leiterplatte 2 geführt sind. Besonders bevorzugt ist jedoch eine Mehrlagenleiterplatte, bei der Leiterbahnen über mehrere parallele Ebenen bzw. Lagen auf den beiden Außenseiten der Leiterplatte und insbesondere auch auf den inneren Zwischenlagen geführt sind. Die Leiterbahnen auf unterschiedlichen Lagen sind in bekannter Weise über sogenannte Durchkontaktierungen oder Vias (elektrische Zwischenverbindungen) miteinander verbunden. Bei den flexibel-starren Leiterplatten kann sich die mehrlagige Führung der Leiterplatten nur auf die starren Bereiche beschränken, während die flexiblen Bereiche Leiterbahnen in nur einer Lage aufweisen können. Die Leiterplatte 2 kann aber auch Leiterbahnen in nur einer Lage der Leiterplatte 2 beispielsweise auf einer Außenseite aufweisen, die beispielsweise mit einem Schutzlack bedeckt sind. Durch die Integration der Leiterbahnen in der Leiterplatte oder die Schutzlackabdeckung ist ein wirksamer Schutz der Leiterbahnen gegenüber Metallspänen und Getriebefluid gewährleistet.

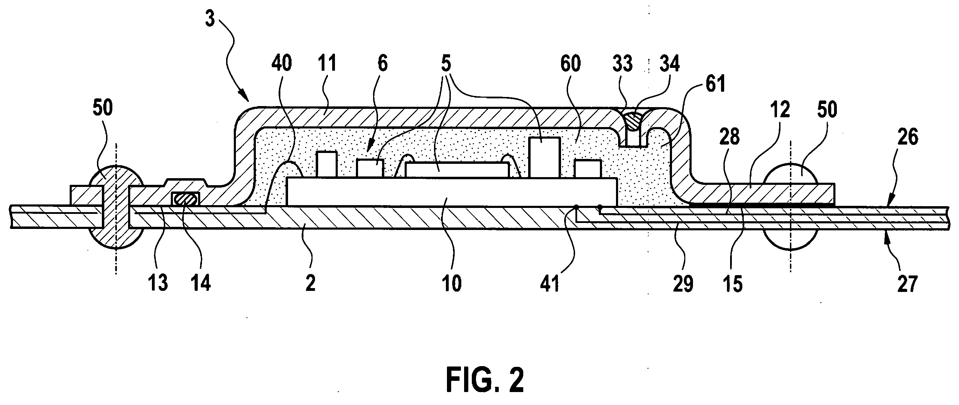

Figur 2 zeigt eine schematische Querschnittsdarstellung des zentralen Teils der Leiterplatte 2 mit dem Steuergerät 3. Die Leiterplatte 2 weist eine erste Seite 26 und eine von dieser abgewandte zweite Seite 27 auf. In Figur 2 ist erkennbar, dass die Leiterplatte 2 eine Mehrlagenleiterplatte ist. Dies ist schematisch durch zwei Leiterbahnen 28 und 29 angedeutet, die auf unterschiedlichen Lagen der Leiterplatte verlaufen, die in zur Längserstreckung der Leiterplatte 2 parallelen Ebenen angeordnet sind, wobei die Leiterbahn 29 beispielsweise auf einer inneren Lage der Leiterplatte angeordnet ist und die Leiterbahn 28 beispielsweise an der Außenseite. Weiterhin ist ein Trägersubstrat 10 dargestellt, das unabhängig von der Leiterplatte 2 hergestellt ist. Das Trägersubstrat 10 dient als Träger eines Teils der elektronischen Steuerschaltung 6, vorzugsweise als Träger der ganzen Steuerschaltung 6. Zu diesem Zweck sind die diskreten elektrischen Bauelemente 5 der Steuerschaltung einzeln auf das Trägersubstrat bestückt und dort mit nicht dargestellten Leiterbahnen des Trägersubstrats 10 kontaktiert. Dies kann in bekannter Weise mittels Drahtbonden, Reflow-Löten oder Leitkleben oder in anderer geeigneter Weise erfolgen. Beispielsweise ist das Trägersubstrat 10 ein keramisches Trägersubstrat, insbesondere ein LTCC-Substrat (Low temperature cofired ceramic) oder eine Mikroleiterplatte. Die elektrische Kontaktierung der zur Steuerschaltung 6 gehörenden elektrischen Bauelemente 5 erfolgt durch die nicht dargestellten Leiterbahnen und Kontakte des Trägersubstrats 10. Das Trägersubstrat kann insbesondere auch ein Mehrlagensubstrat, beispielsweise ein keramisches Multilayersubstrat sein, bei dem die elektrische Verbindung durch Leiterbahnen in mehreren parallelen Ebenen geführt ist, die über sogannte Vias (Zwischenverbinder) elektrisch miteinander verbunden sind. Besonders vorteilhaft ist, dass das Trägersubstrat 10 mit der. Schaltung 6 vorab hergestellt und seine Funktion überprüft werden kann, bevor ein Zusammenbau mit der Leiterplatte 2 erfolgt.

Wie in Fig. 2 weiterhin gezeigt, ist das Trägersubstrat 10 mit der darauf angeordneten Schaltung 6 auf die erste Seite 26 der Leiterplatte 2 aufgebracht. Insbesondere ist es möglich, das Trägersubstrat 10 auf die erste Seite 26 einfach aufzukleben und einzelne Kontakte des Trägersubstrats 10 über Bonddrähte 40 mit den Leiterbahnen auf der ersten Seite 26 oder mit Kontaktflächen auf der ersten Seite 26, die wiederum mittels Vias mit den inneren Leiterbahnen der Leiterplatte verbunden sind, zu kontaktieren. Es ist aber auch möglich, das Trägersubstrat 10 auf der von der Schaltung 6 abgewandten Unterseite mit Lötkontakten 41 zu versehen, die über in dem Trägersubstrat 10 vorgesehene Vias mit der elektronischen Steuerschaltung 6 kontaktiert sind, und das Trägersubstrat 10 mit den Lötkontakten 41 auf Leiterbahnen und/oder Kontaktflächen der ersten Seite 26 der Leiterplatte 2 aufzulöten, wie dies im rechten Bereich des Trägersubstrats 10 in Fig. 2 dargestellt ist.

Nach der Montage des Trägersubstrats 10 auf der Leiterplatte 2 und der Herstellung der elektrischen Kontaktierung zwischen Trägersubstrat und Leiterplatte wird ein wannenförmiges Deckelteil 11, wie in Fig. 2 dargestellt, auf die Leiterplatte 2 aufgesetzt. Das Deckelteil 11 kann aus Metall oder Kunststoff gefertigt sein und beispielsweise als Tiefziehteil, Druckgussteil oder Spritzgussteil kostengünstig gefertigt werden. Das Deckelteil 11 weist einen umlaufenden flanschartigen Kragen 12 auf, der an seiner der Leiterplatte 2 zugewandten Unterseite eine weitgehend ebene Auflagefläche 13 aufweist. In dieser ebenen Auflagefläche 13 kann eine Nut für einen umlaufende Dichtung, beispielsweise ein Dichtring 14 eingebracht sein, wie dies im linken Teil der Figur 2 dargestellt ist. Der Dichtring 14 kann auch eine Elastomerdichtung umfassen. Es ist aber auch möglich, die ebene Auflagefläche 13 mittels einer umlaufenden Dichtklebung 15 auf die erste Seite 26 aufzukleben. Anstelle einer Dichtklebung kann aber auch eine einfache Dichtmasse treten, wenn das Deckelteil durch zusätzliche mechanische Befestigungsmittel an der Leiterplatte festgelegt ist.

Zur mechanischen Befestigung des Deckelteils 11 an der Leiterplatte 2 ist es weiterhin möglich, dass Deckelteil 11 mit zusätzlichen mechanischen Befestigungsmitteln an der Leiterplatte festzulegen. Insbesondere ist es möglich, das Deckelteil 11 wie in Fig. 2 gezeigt beispielsweise mittels Nieten 50 oder Schrauben im Bereich des flanschartigen Kragens 12 an der Leiterplatte zu befestigen. Es ist aber auch möglich, die erste Seite 26 der Leiterplatte mit einer umlaufenden Leiterbahn aus beispielsweise Kupfer zu versehen und ein metallisches Deckelteil auf diese umlaufende Leiterbahn aufzulöten. Weiterhin ist auch denkbar das Deckelteil aus Kunststoff zu fertigen und mit Kunststoffzapfen zu versehen, die durch Warmverstemmung in Durchgangsöffnungen der Leiterplatte 2 festgelegt werden. Ebenso sind Rast- oder Schnappverbindungen oder andere Befestigungsmittel möglich, um das Deckelteil mechanisch an der Leiterplatte 2 festzulegen. Die Längenausdehnungskoeffizienten der Leiterplatte und des Deckelteils können so gewählt werden, dass möglichst geringe thermische Spannungen bei Temperaturwechselbelastungen auftreten. Das Deckelteil 11 bildet einen wirksamen Schutz der Steuerschaltung 6 gegenüber metallischen Spänen, die sich im Hydraulikfluid des Getriebes befinden können.

Nach der Festlegung des Deckelteils 11 kann optional beispielsweise über eine Öffnung 33 in dem Deckelteil 11 eine Dichtheitsprüfung des zwischen dem Deckelteil 11 und der Leiterplatte 2 gebildeten Gehäuseinnenraumes 60 erfolgen. Hierzu kann eine Überdruck- oder Unterdruckbeaufschlagung des Gehäuseinnenraumes 60 über die Öffnung 33 erfolgen, wobei insbesondere die Dichtheit am Ort des Dichtrings 14 beziehungsweise der Dichtklebung 15 geprüft wird. Vorzugsweise ist der Gehäuseinnenraum 60 hermetisch abgedichtet.

Die Öffnung 33 dient aber auch dazu ein fließfähiges Material 61 in den Gehäuseinnenraum 60 einzubringen. Das fließfähige Material 61 wird über dem Trägersubstrat 10 auf die elektrischen Bauelemente 5 aufgetragen und füllt vorzugsweise den gesamten Gehäuseinnenraum 60 aus. Bei dem fließfähigen Material handelt es sich vorzugsweise um ein chemisch neutrales Material, dass die elektrischen Bauelemente 5 und Kontakte des Trägersubstrats 10 nicht angreift. Hier können insbesondere Gele und Flüssigkeiten verwandt werden, wobei die elektronische Schaltung 6 zusätzlich mit einem isolierenden Schutzlack überzogen sein kann oder beispielweise ein elektrisch nicht leitendes Material 61 direkt auf die Bauelemente 5 aufgebracht wird. Das fließfähige Material in dem Gehäuseinnenraum verhindert ein Eindringen von Getriebefluid und eine Kontamination der elektronischen Schaltung.

Vorzugsweise handelt es sich beim dem fließfähigen Material 61 um ein wärmeleitendes Material, insbesondere einen wärmeleitendes Gel. Wenn der Gehäuseinnenraum 60 vorzugsweise vollständig mit dem wärmeleitenden Material aufgefüllt wird, so wie dies in Fig. 2 dargestellt ist, dann resultiert hieraus ein guter Wärmeleitkontakt zwischen der elektronischen Schaltung 6 und dem Deckelteil 11. Im Betrieb erzeugte Wärme wird dann wenigstens teilweise von der Schaltung 6 über das wärmeleitende Material 61 an das Deckelteil 11 abgegeben. Um diese Wärmeableitung zu verbessern, ist es weiterhin vorteilhaft, einen Kühlkörper 55 über dem Deckelteil 11 vorzusehen, wie dies in Figur 3 dargestellt ist. Der Kühlkörper 55 kann eine Metallplatte sein, die direkt oder indirekt über ein Wärmeleitmaterial mit dem Deckelteil 11 in Wärmekontakt steht. Der Kühlkörper 55 kann beispielsweise ein Teil des Grundkörpers 1 des Getriebesteuermoduls sein.

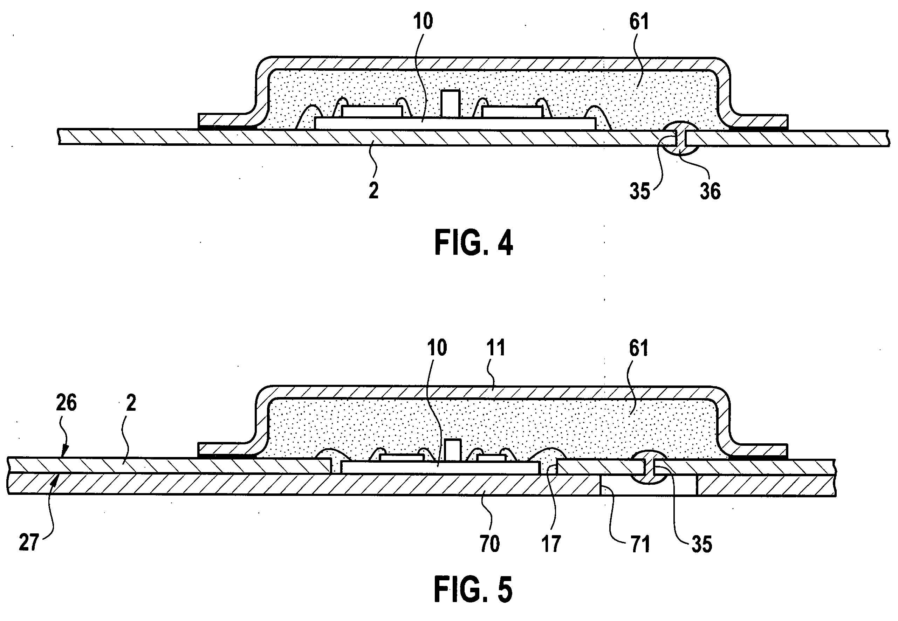

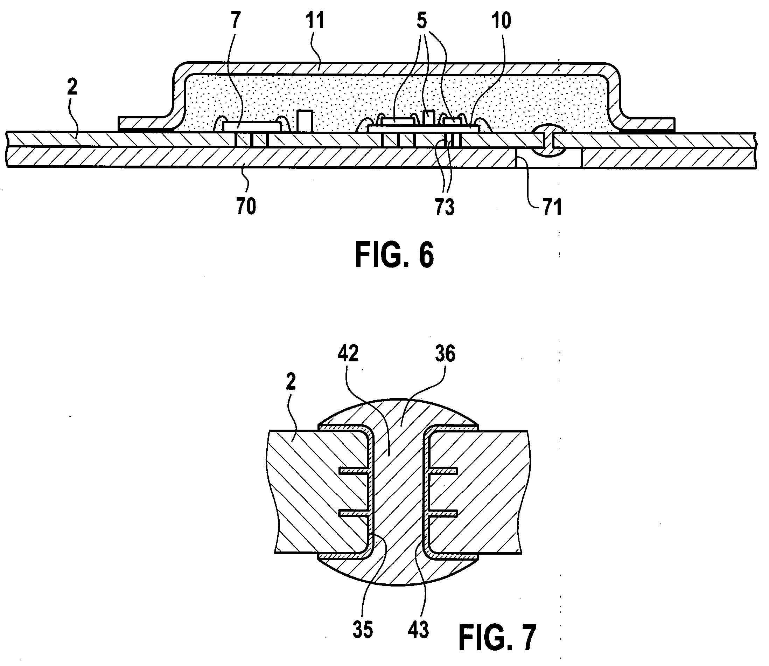

Ein weiteres Ausführungsbeispiel eines erfindungsgemäßen Steuermoduls ist in Figur 4 dargestellt, wobei im Folgenden nur auf die Unterschiede zur Figur 2 eingegangen wird. Bei dem Ausführungsbeispiel in Figur 4 ist die zur Einfüllung des fließfähigen Materials 61 vorgesehene Öffnung 35 nicht in dem Deckelteil 11, sondern in der Leiterplatte 2 vorgesehen. Dabei kann die Öffnung 35 auf besonders einfache Weise durch eine Durchkontaktierung 43 der Leiterplatte 2 dargestellt werden. Eine vergrößerte Darstellung der Durchkontaktierung 43 ist in Figur 7 erkennbar. Durchkontaktierung dienen in Mehrlagenleiterplatte zur Kontaktierung von Leiterbahnen auf unterschiedlichen Lagen der Mehrlagenleiterplatte. Durchkontaktierungen werden bei der üblichen Herstellung derartiger starrer Leiterplatten ohnehin vorgesehen, so dass kein Mehraufwand für die Herstellung erforderlich ist. Die Durchkontaktierung 43 weist eine auf die Innenwandung einer Durchgangsausnehmung 42 aufgetragene elektrisch leitfähige Beschichtung aus z.B. Kupfer auf, die auf der ersten Seite 26 und der zweiten Seite 27 der Leiterplatte mit Lötaugen versehen ist. Zwei mit der Durchkontaktierung 43 verbundene innere Lagen sind in Figur 7 angedeutet. Die Durchkontaktierung 43 kann aber auch speziell angepasst sein. So kann zur besseren Haftung an der Leiterplatte der Durchmesser der Lötaugen vergrößert sein und die Innenlagen der Leiterplatte können mit der Durchkontaktierung verbunden sein, um ein Dichtlabyrinth zu realisieren.

Über die zunächst offene Durchgangsausnehmung 42 kann eine Dichtheitsprüfung des Gehäuseinnenraumes 60 erfolgen. Ebenso ist die Einfüllung des fließfähigen Materials durch die Durchgangsausnehmung 42 möglich, beispielsweise mit einer Dispensvorrichtung. Nach der Befüllung des Gehäuseinnenraumes wird ein Verschlusselement 36 in der Form von Lot in die Durchgangsausnehmung 42 eingebracht. Hierzu kann ein punktueller Lotauftrag von Weichlot auf die zweite Seite 27 der Leiterplatte 2 erfolgen, wobei unter Wärmezuführung das Lot schmilzt und sich in die Durchgangsöffnung 42 hineinzieht. Natürlich kann die Durchgangsöffnung 42 auch auf andere Weise verschlossen werden.

Figur 5 zeigt ein Ausführungsbeispiel bei dem zusätzlich zu dem in Figur 4 dargestellten Ausführungsbeispiel eine metallische Platte 70 aus beispielsweise Aluminium auf die zweite Seite 27 der Leiterplatte 2 aufgetragen ist. Diese kann unmittelbar oder durch Kleben, Löten Auflaminieren oder andere Techniken erfolgen. Die metallische Platte 70 weist eine Ausnehmung 71 auf, welche einen Zugang zu der Öffnung 35 erlaubt, damit auch in dieser Ausführungsform eine Befüllung des Gehäuseinnenraumes über eine Öffnung in der Leiterplatte 2 erfolgen kann. Weiterhin weist die Leiterplatte 2 eine Aussparung 17 auf. Innerhalb dieser Aussparung 17 ist das Trägersubstrat 10 mit der elektronischen Steuerschaltung 6 auf die metallische Platte 70 aufgebracht, beispielsweise aufgeklebt oder aufgelötet. Die Kontaktierung zwischen Leiterplatte 2 und Trägersubstrat 10 erfolgt hier vorzugsweise über Bondrähte. Bei diesem Ausführungsbeispiel wird der Gehäuseinnenraum 61 durch den Bereich zwischen der Innenseite des Deckelteils 11 und der durch die zweite Seite 27 der Leiterplatte 2 gebildete Unterseite der Leiterplatte 2 gebildet. Im Kontext der Anmeldung ist daher unter einem zwischen dem Deckelteil und der Leiterplatte gebildeten Gehäuseinnenraum der Bereich zwischen der Innenseite des Deckelteils und der von dem Deckteil abgewandten zweiten Seite 27 der Leiterplatte 2 zu verstehen. Das Ausführungsbeispiel in Figur 5 weist den Vorteil auf, dass die Wärmeableitung der von den Bauelementen 5 der Schaltung 6 erzeugten Wärme nicht nur über das wärmeleitende Material 61 hin zum Deckelteil 11 erfolgt, sondern auch über das Trägersubstrat 10 zur metallischen Platte 70 hin erfolgen kann.

Ein weiteres Ausführungsbeispiel ist in der Figur 6 dargestellt. In diesem Ausführungsbeispiel ist das Trägersubstrat 10 wie bei dem Ausführungsbeispiel der Figur 2 auf die erste Seite 26 der Leiterplatte aufgebracht. Auf dem Trägersubstrat ist aber nur ein Teil der elektronischen Steuerschaltung angeordnet. Auf die zweite Seite 27 der Leiterplatte 2 ist eine metallische Platte 70 aufgebracht. Die Platte 70 kann beispielsweise auf die Leiterplatte aufgeklebt oder aufgelötet sein. Durchkontaktierungen 73 in der Leiterplatte 2 verbessern die Wärmeableitung, wenn die von Bauelementen auf dem Trägersubstrat 10 abgegebene Wärme über das Trägersubstrat 10 und die Durchkontaktierungen 73 auf die zweite Seite 27 der Leiterplatte 2 und von dort zur metallischen Platte 70 gelangt. Die Durchkontaktierungen können zu diesem Zweck mit Lot gefüllt sein. In diesem Ausführungsbeispiel sind neben dem Trägersubstrat 10 darüber hinaus innerhalb des von Deckteil 11 und Leiterplatte 2 gebildeten Gehäuseinnenraumes 61 weitere zur elektronischen Steuerschaltung 6 gehörende Bauelemente 7 direkt auf die Leiterplatte 2 bestückt. Auch für diese Bauelemente 7 kann die Wärmeabfuhr über Durchkontaktierungen der Leiterplatte 2 auf die metallische Platte 70 erfolgen. Die elektrische Verbindung zum Trägersubstrat 10 erfolgt über Leiterbahnen der Leiterplatte 2 und Bonddrähte.

## Patentansprüche

1. Steuermodul, insbesondere Getriebesteuermodul, mit einer als Grundträger der elektrischen Verbindungstechnik vorgesehenen Leiterplatte (2), die auf wenigstens einer Ebene der Leiterplatte angeordnete Leiterbahnen (28) und wenigstens einen starren, nicht flexiblen Leiterbahnabschnitt (20) aufweist, und mit einer mit den Leiterbahnen (28) der Leiterplatte elektrisch kontaktierten und elektrische Bauelemente (5) aufweisenden elektronischen Steuerschaltung (6) sowie mit einem zum Schutz der Steuerschaltung (6) vorgesehenen wannenförmigen Deckelteil (11), das wenigstens über einem Teil der elektronischen Steuerschaltung (6) angeordnet ist und mit einem parallel zu einer ersten Seite der Leiterplatte (2) ausgerichteten ebenen Auflagebereich (13) auf der ersten Seite (26) der Leiterplatte (2) dichtend aufliegt, wobei wenigstens ein Teil der elektronischen Steuerschaltung (6) in einem zwischen dem Deckelteil (11) und der Leiterplatte (2) gebildeten Gehäuseinnenraum (60) geschützt angeordnet ist und elektrische Kontakte der Leiterplatte (2) außerhalb des von dem Deckelteil (11) abgedeckten Gehäuseinnenraums (60) zur Kontaktierung von elektrischen Komponenten (30,31,32) des Steuermoduls vorgesehen sind, **dadurch gekennzeichnet, dass** wenigstens ein Teil der elektronischen Steuerschaltung (6) auf einem in dem Gehäuseinnenraum (60) angeordneten Trägersubstrat (10) angeordnet ist, das mit den Leiterbahnen (28, 29) oder Kontaktflächen der Leiterplatte (2) elektrisch kontaktiert ist, und dass in den Gehäuseinnenraum über den elektrischen Bauelementen (5) und dem Trägersubstrat (10) ein fließfähiges Material (61) eingefüllt ist, wobei das fließfähige Material (61) den nicht durch das Trägersubstrat (10) und die elektrischen Bauelemente (5) belegten Teil des Gehäuseinnenraumes (60) weitgehend ausfüllt und vorzugsweise vollkommen ausfüllt.

2. Steuermodul nach Anspruch 1, **dadurch gekennzeichnet, dass** in dem Deckelteil (11) und/oder in der Leiterplatte (2) wenigstens eine mit einem Verschlusselement (34, 36) verschließbare Öffnung (33, 35) zur Einfüllung des wärmeleitenden Materials (61) vorgesehen ist

3. Steuermodul nach Anspruch 1, **dadurch gekennzeichnet, dass** das fließfähige Material (61) wärmeleitend ist und einen Wärmeleitkontakt zwischen den elektrischen Bauelementen (5) und dem Deckelteil (11) bildet.

4. Steuermodul nach Anspruch 1, **dadurch gekennzeichnet, dass** ein Kühlkörper (55) über dem Deckelteil (11) angeordnet ist, der mit dem Deckelteil (11) in Wärmeleitkontakt steht.

5. Steuermodul nach Anspruch 2, **dadurch gekennzeichnet, dass** die wenigstens eine verschließbare Öffnung (33) in dem Deckelteil (11) ausgeblldet ist und dass das Verschlusselement (34) ein in die Öffnung (33) eingepresstes, insbesondere kugelförmiges Einpressteil umfasst.

6. Steuermodul nach Anspruch 2, **dadurch gekennzeichnet, dass** die wenigstens eine verschließbare Öffnung (35) in Form wenigstens einer mit einer zentrischen Durchgangsausnehmung (42) versehenen Durchkontaktierung (43) in der Leiterplatte (2) vorgesehen ist und das Verschlusselement (36) in Form von Lot in die zentrische Durchgangsausnehmung (42) der Durchkontaktierung eingebracht ist.

7. Steuermodul nach Anspruch 1, **dadurch gekennzeichnet, dass** das Trägersubstrat (10) als Mehrlagensubstrat, insbesondere als keramisches Mehrlagensubstrat (LTCC) oder als Mikroleiterplatte ausgebildet ist.

8. Steuermodul nach Anspruch 1, **dadurch gekennzeichnet, dass** das Trägersubstrat (10) auf der ersten Seite (26) der Leiterplatte (2) festgelegt ist, insbesondere dort aufgeklebt oder aufgelötet ist.

9. Steuermodul nach Anspruch 1, **dadurch gekennzeichnet, dass** eine metallische Grundplatte (70) auf die zweite Seite (27) der Leiterplatte (2) aufgebracht ist und das Trägersubstrat (10) innerhalb einer in der Leiterplatte (2) vorgesehenen Ausnehmung (17) auf die metallische Grundplatte (70) aufgebracht ist.

10. Verfahren zur Verstellung eines Steuermoduls nach Anspruch 8 oder 9, **gekennzeichnet durch** folgende Schritte:
- Bereitstellen eines mit einer elektronischen Steuerschaltung (6) versehenen Trägersubstrats (10),
- Aufbringung des Trägersubstrats (10) auf eine Leiterplatte (2) oder Aufbringung des Trägersubstrats (10) innerhalb einer Ausnehmung (17) einer Leiterplatte (2) auf eine mit der Leiterplatte (2) verbundene metallische Grundplatte (70),
- Herstellung einer elektrischen Verbindung zwischen der elektronischen Steuerschaltung (6) auf dem Trägersubstrat (10) und den Leiterbahnen (28, 29) oder Kontaktflächen der Leiterplatte,
- Aufsetzen eines wannenförmigen Deckelteils (11) über der elektronischen Steuerschaltung (6), so dass das wannenförmige Deckelteil mit einem ebenen Auflagebereich (13) unter Herstellung einer umlaufend dichten Verbindung auf einer ersten Seite (26) der Leiterplatte aufliegt,
- Einfüllung eines fließfähigen Materials (61) **durch** wenigstens eine Öffnung (33, 35) in dem Deckelteil (11) oder der Leiterplatte (2) in den zwischen dem Deckelteil (11) und der Leiterplatte (2) gebildeten Gehäuseinnenraum (60), wobei das fließfähige Material (61) den nicht **durch** das Trägersubstrat (10) und die elektrischen Bauelemente (5) belegten Teil des Gehäuseinnenraumes (60) weitgehend ausfüllt und vorzugsweise vollkommen ausfüllt, und
- Verschließen der Öffnung (33, 35) mit einem Verschlusselement (34, 36).

11. Verfahren nach Anspruch 10, **dadurch gekennzeichnet, dass** vor dem Prozessschritt des Einfüllens des fließfähigen Materials (61) über die Öffnung (33, 35) eine Dichtheitsprüfung des Gehäuseinnenraums (60) durch eine Überdruck- oder Unterdruckbeaufschlagung erfolgt.

## Claims

1. Control module, in particular transmission control module, having a circuit board (2) that is provided as a base carrier in the electrical connection technology, which circuit board comprises conductor paths (28), which are arranged at least on one plane of the circuit board, and at least one rigid, non-flexible conductor path region (20), and said control module having an electronic control circuit (6), which is electrically contacted by the conductor paths (28) of the circuit board and comprises electrical components (5), and said control module having a bowl-shaped cover part (11) that is provided as a protection for the control circuit (6) and said bowl-shaped cover part is arranged at least over a part of the electronic control circuit (6) and lies in a sealing manner on the first face (26) of the circuit board (2) by means of a planar contact region (13) that is aligned in parallel to a first face of the circuit board (2), wherein at least a part of the electronic control circuit (6) is arranged in a protected manner in a housing inner chamber (60) that is formed between the cover part (11) and the circuit board (2) and in order to contact the electrical components (30, 31, 32) of the control module electrical contacts of the circuit board (2) are provided outside the housing inner camber (60) that is covered by the cover part (11), **characterized in that** at least one part of the electronic control circuit (6) is arranged on a carrier substrate (10) that is arranged in the housing inner chamber (60), which carrier substrate is electrically contacted by the conductor paths (28, 29) or contact areas of the circuit board (2) and that a flowable material (61) is introduced into the housing inner chamber and flows over the electrical components (5) and the carrier substrate (10), wherein the flowable material (61) to a great extent fills and preferably completely fills the part of the housing inner chamber (60) that is not covered by the carrier substrate (10) and the electrical components (5).

2. Control module according to Claim 1, **characterized in that** at least one orifice (33, 35) that can be sealed by means of a sealing element (34, 36) is provided in the cover part (11) and/or in the circuit board (2) for the purpose of introducing the heat-conducting material (61).

3. Control module according to Claim 1, **characterized in that** the flowable material (61) can conduct heat and forms a heat-conducting contact between the electrical components (5) and the cover part (11).

4. Control module according to Claim 1, **characterized in that** a cooling body (55) that is in heat-conducting contact with the cover part (11) is arranged over the cover part (11).

5. Control module according to Claim 2, **characterized in that** the at least one sealable orifice (33) is embodied in the cover part (11) and that the sealing element (34) comprises a press-in part that is in particular ball-shaped and is pressed into the orifice (33).

6. Control module according to Claim 2, **characterized in that** the at least one sealable orifice (35) is provided in the form of at least one through-connection (43) that is provided with a central through-going cut-out (42) in the circuit board (2) and the sealing element (36) is applied in the form of solder into the central through-going cut-out (42) of the through-connection.

7. Control module according to Claim 1, **characterized in that** the carrier substrate (10) is embodied as a multi-layer substrate, in particular as a ceramic multi-layer substrate (LTCC) or as a micro circuit board.

8. Control module according to Claim 1, **characterized in that** the carrier substrate (10) is fastened to the first face (26) of the circuit board (2), in particular is adhered thereto or soldered thereto.

9. Control module according to Claim 1, **characterized in that** a metal base plate (70) is mounted on the second face (27) of the circuit board (2) and the carrier substrate (10) is mounted within a cut-out (17) on the metal base plate (70), which cut-out is provided in the circuit board (2).

10. Method for producing a control module according to Claim 8 or 9, **characterized by** the following steps:
- Provide a carrier substrate (10) that is provided with an electronic control circuit (6),
- Mount the carrier substrate (10) on a circuit board (2) or mount the carrier substrate (10) within a cut-out (17) in a circuit board (2) on a metal base plate (70) that is connected to the circuit board (2),
- Produce an electrical connection between the electronic control circuit (6) on the carrier substrate (10) and the conductor paths (28, 29) or contact areas on the circuit board,
- Place a bowl-shaped cover part (11) over the electronic control circuit (6) so that the bowl-shaped cover part lies with a planar contact area (13) on a first face (26) of the circuit board to produce a circumferential sealed connection, Introduce a flowable material (61) through at least one orifice (33, 35) in the cover part (11) or in the circuit board (2) into the housing inner chamber (60) that is formed between the cover part (11) and the circuit board (2) the flowable material (61) to a great extent fills and preferably completely fills the part of the housing inner chamber (60) that is not covered by the carrier substrate (10) and the electrical components (5), and
- Seal the orifice (33, 35) by means of a sealing element (34, 36).

11. Method according to Claim 10, **characterized in that** prior to the method step of introducing the flowable material (61) by way of the orifice (33, 35) a leak test is performed on the housing inner chamber (60) by means of applying an overpressure or an underpressure.

## Revendications

1. Module de commande, notamment module de commande d'engrenage, comprenant un circuit imprimé (2) réalisé sous la forme d'un support de base de la connectique électrique, lequel possède des pistes conductrices (28) disposées sur au moins un plan du circuit imprimé et au moins une portion de piste conductrice (20) rigide non souple, et comprenant un circuit de commande (6) électronique en contact électrique avec les pistes conductrices (28) du circuit imprimé et possédant des composants électriques (5) ainsi qu'une partie formant couvercle (11) en forme de cuvette destinée à la protection du circuit de commande (6), laquelle est disposée au moins au-dessus d'une partie du circuit de commande (6) électronique et comprenant une zone d'appui (13) plane orientée parallèlement à un premier côté du circuit imprimé (2) et reposant de manière étanche sur le premier côté (26) du circuit imprimé (2), au moins une partie du circuit de commande (6) électronique étant disposée protégée dans un espace intérieur de boîtier (60) formé entre la partie formant couvercle (11) et le circuit imprimé (2) et des contacts électriques du circuit imprimé (2) étant présents à l'extérieur de l'espace intérieur de boîtier (60) recouvert par la partie formant couvercle (11) en vue d'établir le contact avec des composants électriques (30, 31, 32) du module de commande, **caractérisé en ce qu'**au moins une partie du circuit de commande (6) électronique est disposée sur un substrat porteur (10) disposé à l'intérieur de l'espace intérieur de boîtier (60), laquelle est en contact électrique avec les pistes conductrices (28, 29) ou des surfaces de contact du circuit imprimé (2), et **en ce que** l'espace intérieur de boîtier au-dessus des composants électriques (5) et du substrat porteur (10) est rempli d'un matériau coulant (61), le matériau coulant (61) remplissant amplement et de préférence remplissant entièrement la partie de l'espace intérieur de boîtier (60) non occupée par le substrat porteur (10) et les composants électriques (5).

2. Module de commande selon la revendication 1, **caractérisé en ce qu'**au moins une ouverture (33, 35) pouvant être fermée avec un élément de fermeture (34, 36) et servant au remplissage avec le matériau thermoconducteur (61) se trouve dans la partie formant couvercle (11) et/ou dans le circuit imprimé (2).

3. Module de commande selon la revendication 1, **caractérisé en ce que** le matériau coulant (61) est thermoconducteur et forme un contact de thermoconduction entre les composants électriques (5) et la partie formant couvercle (11).

4. Module de commande selon la revendication 1, **caractérisé en ce qu'**un radiateur (55) est monté au-dessus de la partie formant couvercle (11), lequel se trouve en contact de thermoconduction avec la partie formant couvercle (11).

5. Module de commande selon la revendication 2, **caractérisé en ce que** l'au moins une ouverture (33) pouvant être fermée est formée dans la partie formant couvercle (11) et **en ce que** l'élément de fermeture (34) comprend une partie à enfoncer, notamment sphérique, enfoncée dans l'ouverture (33).

6. Module de commande selon la revendication 2, **caractérisé en ce que** l'au moins une ouverture (35) pouvant être fermée est réalisée sous la forme d'au moins un contact traversant (43) muni d'une cavité traversante centrée (42) dans le circuit imprimé (2), et l'élément de fermeture (36) est introduit sous la forme de brasure dans la cavité traversante centrée (42) du contact traversant.

7. Module de commande selon la revendication 1, **caractérisé en ce que** le substrat porteur (10) est réalisé sous la forme d'un substrat multicouche, notamment sous la forme d'un substrat multicouche en céramique (LTCC) ou d'un micro-circuit imprimé.

8. Module de commande selon la revendication 1, **caractérisé en ce que** le substrat porteur (10) est fixé sur le premier côté (26) du circuit imprimé (2), notamment en y étant collé ou brasé.

9. Module de commande selon la revendication 1, **caractérisé en ce qu'**une plaque de base métallique (70) est montée sur le deuxième côté (27) du circuit imprimé (2) et le substrat porteur (10) est monté sur la plaque de base métallique (70) à l'intérieur d'une cavité (17) présente dans le circuit imprimé (2).

10. Procédé de fabrication d'un module de commande selon la revendication 8 ou 9, **caractérisé par** les étapes suivantes :
- fourniture d'un substrat porteur (10) pourvu d'un circuit de commande (6) électronique,
- dépose du substrat porteur (10) sur un circuit imprimé (2) ou dépose du substrat porteur (10) à l'intérieur d'une cavité (17) d'un circuit imprimé (2) sur une plaque de base métallique (70) reliée au circuit imprimé (2),
- établissement d'une liaison électrique entre le circuit de commande (6) électronique sur le substrat porteur (10) et les pistes conductrices (28, 29) ou des surfaces de contact du circuit imprimé,
- pose d'une partie formant couvercle (11) en forme de cuvette sur le circuit de commande (6) électronique, de sorte que la partie formant couvercle en forme de cuvette repose avec une zone d'appui (13) plane sur un premier côté (26) du circuit imprimé en établissant une liaison périphérique étanche,
- remplissage avec un matériau coulant (61), à travers au moins une ouverture (33, 35) dans la partie formant couvercle (11) ou le circuit imprimé (2), de l'espace intérieur de boîtier (60) formé entre la partie formant couvercle (11) et le circuit imprimé (2), le matériau coulant (61) remplissant amplement et de préférence remplissant entièrement la partie de l'espace intérieur de boîtier (60) non occupée par le substrat porteur (10) et les composants électriques (5), et
- fermeture de l'ouverture (33, 35) avec un élément de fermeture (34, 36).

11. Procédé selon la revendication 10, **caractérisé en ce qu'**un contrôle de l'étanchéité de l'espace intérieur de boîtier (60) par une charge en surpression ou en dépression est effectué avant l'étape du procédé de remplissage avec le matériau coulant (61), par le biais de l'ouverture (33, 35).
